Europäisches Patentamt

(19) European Patent Office

Office européen des brevets

(11) Publication number: **0 000 630**
**B1**

## (12) EUROPEAN PATENT SPECIFICATION

(45) Date of publication of patent specification: **15.07.81**

(51) Int. Cl.³: **H 05 K 7/10, H 01 R 23/00**

(21) Application number: **78300137.3**

(22) Date of filing: **10.07.78**

(54) Microcircuit modules interconnector socket.

(30) Priority: **02.08.77 US 821112**

(43) Date of publication of application:
**07.02.79 Bulletin 79/3**

(45) Publication of the grant of the European patent:
**15.07.81 Bulletin 81/28**

(84) Designated Contracting States:
**BE DE FR GB NL SE**

(56) References cited:
**US - A - 2 816 253
US - A - 3 359 461
US - A - 3 784 960**

(73) Proprietor: **AMP INCORPORATED
Eisenhower Boulevard
Harrisburg, Pennsylvania (US)**

(72) Inventor: **Grabbe, Dimitry G.
301 Main Street
Lisbon Falls Maine 04252 (US)**
Inventor: **Sweeney, Joseph Patrick
R.D. No. 7 Box 195A
Carlisle Pennsylvania 17013 (US)**

(74) Representative: **Stuart-Prince, Richard Geoffrey et al,
20 Queensmere
Slough, Berkshire SL1 1YZ (GB)**

Courier Press, Leamington Spa, England.

## Microcircuit modules interconnector socket

This invention relates to an electrical connector and microcircuit module assembly.

Until fairly recent times, solid state microelectronic devices were packaged in prismatic rectangular insulating bodies having leads extending from two opposite sides of the bodies. More recently, such modules have been produced in square form having leads extending from all four sides thereof, and these new generation modules are somewhat smaller than the previous modules, notwithstanding the fact that the new modules require more leads.

A standard module form is being used for the newest family of microcircuit devices, this module comprising a square, low-profile body having at least six leads extending from each side thereof. It is common practice to mount modules of this type directly on to printed circuit boards or similar substrates, or to removably mount such modules in sockets, each dimensioned to receive a single module.

In the rapidly developing microelectronics industry, added requirements are continually emerging from microcircuit modules so that a packaging arrangement which may be entirely satisfactory for the modules being produced today may be totally incapable of accommodating, and providing the necessary interconnections for, the modules which will be available only a few years hence. For example, modules such as microprocessor modules are presently being manufactured, which have an information capacity of 4000 information bits. Within the next few years, modules having the same dimensions as presently available modules will probably have a capacity of 8000 bits, and it is also foreseen that 16000 bit modules will be available shortly thereafter. It follows that manufacturers who adopt a packaging arrangement capable of accommodating only the presently available modules will probably be faced with a problem in the near future, of changing over to an arrangement having the capability of handling the expected new modules.

In U.S. Patent Specification No. 2816253 there is disclosed an assembly of an electrical connector comprising a hollow prismatic housing of electrically insulating plastics material having a plurality of parallel electrical conductors extending along the inner faces of its walls, the conductors having portions extending from a common end of the housing for connection to conductors on a substrate, and a plurality of microcircuit modules received in superposed relationship in the housing, each module comprising a body having a plurality of leads extending therefrom, the leads being in contact with the conductors on the inner faces of the walls of the connector housing.

In this known assembly the conductors of the connector are broken at predetermined positions in order that the connector will provide the required interconnections between the modules received in the connector.

However, such a method of providing the required interconnections results in a connector which is suitable for receiving only a particular plurality of modules, and if the interconnections need to be changed or a different plurality of modules are to be used, then the connector must be replaced by a different connector adapted to provide the newly required interconnections.

According to this invention an assembly as set out above is characterised in that the conductors are all uninterrupted throughout their length, at least some of the modules being allotted individually dedicated conductors, each such module not having leads connected to the conductors allotted to other modules but having a lead connected to the individually dedicated conductor, the conductors not individually dedicated to particular modules serving for connections to all the modules in the connector.

With the assembly according to this invention the connector when once mounted on a substrate need not be removed when different interconnections between the modules are required or when different modules are to be used, since the necessary adaptation of the assembly is effected by adaptation of the leads of the modules.

This invention will now be described by way of example with reference to the drawings, in which:—

Figure 1 is a perspective view of an assembly according to this invention together with a substrate on which the assembly is to be mounted; and

Figure 2 is a vertical section through the assembly of Figure 1 with part broken away.

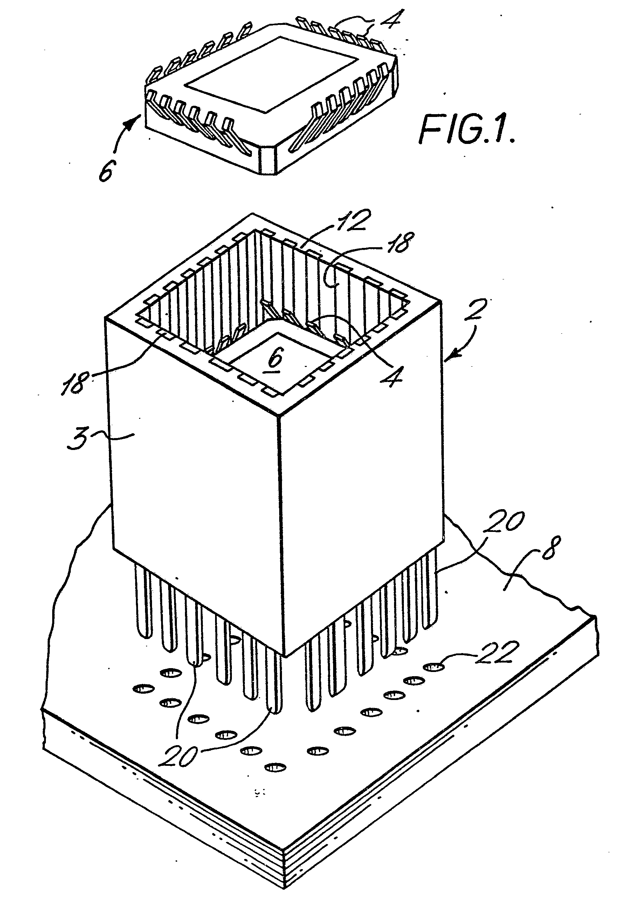

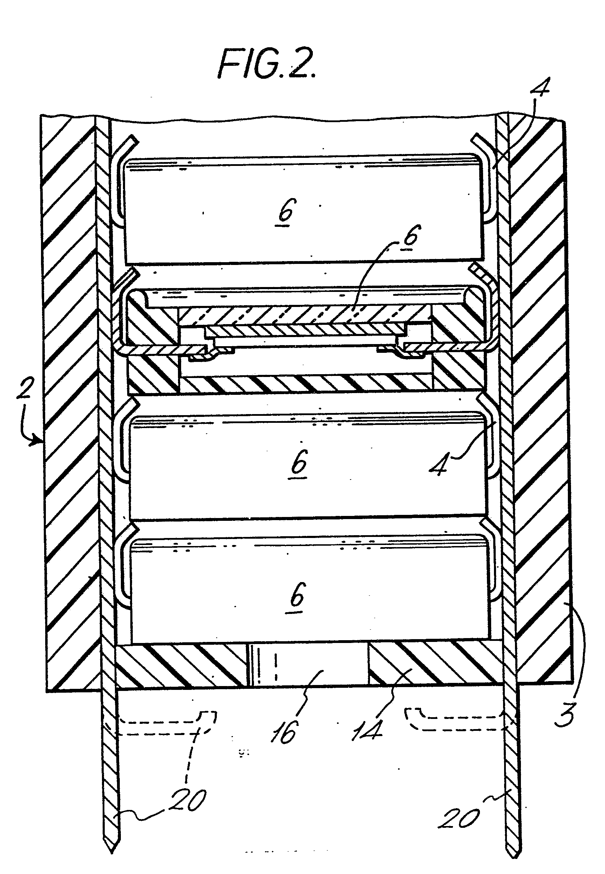

The connector 2 shown in Figures 1 and 2 is for connecting leads 4 of a plurality of microcircuit modules 6 to conductors (not shown) on a printed circuit board 8.

The connector 2 comprises a hollow prismatic housing 3 of electrically insulating material, having a square cross-section, and having an open end 12 into which the modules 6 can be inserted. The other end of the housing is closed by a bottom cover member 14 having a central opening 16 therein to permit removal of the modules 6 from the interior of the connector. A plurality of spaced, straight, parallel conductors 18 extend uninterrupted along the inner faces of the walls of the housing 3, and portions 20 of the conductors 18 project beyond the other end of the housing so that they can be received in holes 22 in the board 8, and then soldered to conductors on the underside of the board 8.

The conductors 18 are arranged to be contacted by the leads 4 of the modules 6 when received in the housing 3, and thus the connector serves to connect the modules 6 received therein to the conductors on the board 8.

Instead of passing through holes in the board 8 the conductor portions 20 can be bent as shown in dashed line in Figure 2 for connection to conductors on the top side of the board 8. The conductors 18 can be of high purity copper since they do not serve as spring members, but the leads 4 of the modules 6 should be of spring metal such as beryllium copper or phosphor bronze.

When a plurality of the modules 6 are placed in the connector 2 in the same orientation, corresponding leads 4 of the modules 6 will contact the same conductor 18 in the housing 3. The modules 6 will thus be connected in parallel to the conductors 18 and to the conductors on the printed circuit board 8.

In use, it will be necessary for certain modules 6 to be energised individually at any particular instant, and to this end at least some of the modules 6 received in the housing 3 are allotted individually dedicated conductors 18, each such module 6 not having leads 4 connected to the conductors 18 allotted to other modules 6 but having an energisation lead 4 connected to the individually dedicated conductor 18.

The conductors 18 not individually dedicated to particular modules 6 serve all the modules 6 in the connector 2.

The modules 6 are removed from the housing 3 simply by pushing the modules 6 upwardly as seen in Figure 2, access to the lowermost module 6 being provided by the opening 16.

## Claim

1. An assembly of an electrical connector (2) comprising a hollow prismatic housing (3) of electrically insulating plastics material having a plurality of parallel electrical conductors (18) extending along the inner faces of its walls, the conductors having portions (20) extending from a common end of the housing for connection to conductors on a substrate (8), and a plurality of microcircuit modules (6) received in superposed relationship in the housing, each module comprising a body having a plurality of leads (4) extending therefrom, the leads being in contact with the conductors on the inner faces of the walls of the connector housing, *characterised in that* the conductors (18) are all uninterrupted throughout their length, at least some of the modules (6) being allotted individually dedicated conductors (18), each such module (6) not having leads (4) connected to the conductors (18) allotted to other modules (6) but having a lead (4) connected to the individually dedicated conductor (18), the conductors (18) not individually dedicated to particular modules (6) serving for connections to all the modules (6) in the connector (2).

## Patentanspruch:

1. Aufbau aus einem elektrischen Verbinder (2), der ein hohles prismatisches Gehäuse (3) aus elektrisch isolierendem Kunststoffmaterial aufweist, in welchem eine Vielzahl von parallelen elektrischen Leitern (18) sich entlang der inneren Flächen seiner Wände erstreckt, wobei die Leiter Teile (20) aufweisen, die sich von einem gemeinsamen Ende des Gehäuses zur Verbindung der Leiter mit Leitern auf einem Substrat (8) wegerstrecken, und aus einer Vielzahl von in übereinanderliegender Beziehung in dem Gehäuse aufgenommenen Mikroschaltungsmodulen (6), von denen jeder Modul einen Körper mit einer Vielzahl von Leitungen (4) aufweist, die sich von ihm wegerstrecken und die mit den Leitern auf den inneren Flächen der Wände des Verbindergehäuses in Kontakt stehen, dadurch gekennzeichnet, daß die Leiter (18) alle über ihre Länge hinweg ununterbrochen sind, daß wenigstens einigen der Module (6) individuell zugewiesene Leiter (18) zugeordnet sind, daß bei jedem dieser Module (6) Leitungen (4) nicht mit den Leitern (18) verbunden sind, die anderen Modulen (6) zugeordnet sind, sondern eine Leitung (4) mit dem individuell zugewiesenen Leiter (18) verbunden ist, und daß die nicht individuell bestimmten Modulen (6) zugewiesenen Leiter (18) zur Verbindung all der Module (6) in dem Verbinder (2) dienen.

## Revendication

Ensemble à connecteur électrique (2) comprenant un boîtier prismatique creux (3) en matière plastique électriquement isolante, comportant plusieurs conducteurs électriques parallèles (18) qui s'étendent le long des faces intérieures de ses parois, les conducteurs comportant des tronçons (20) qui dépassent d'une extrémité commune du boîtier afin d'être connectés à des conducteurs situés sur un substrat (8) et plusieurs modules (6) à microcircuits logés en superposition dans le boîtier, chaque module comprenant un corps duquel dépasse plusieurs organes conducteurs (4), les organes conducteurs étant en contact avec les conducteurs situés sur les faces intérieures des parois du boîtier du connecteur, caractérisé en ce que les conducteurs (18) sont tous ininterrompus sur toute leur longueur, au moins certains des modules (6) étant dotés de conducteurs (18) qui leur sont attribués individuellement, chacun de ces modules (6) ne possédant pas d'organes conducteurs (4) connectés aux conducteurs (18) attribués à d'autres modules (6), mais possédant un organe conducteur (4) connecté au conducteur (18) attribué individuellement, les conducteurs (18) qui ne sont pas attribués individuellement à des modules particuliers (6) servant aux connexions pour tous les modules (6) placés dans le connecteur (2).

FIG.1.

# FIG.2.